# EUROPÄISCHE PATENTSCHRIFT

(11) **EP 2 643 795 B1**
(45) Veröffentlichungstag und Bekanntmachung des Hinweises auf die Patenterteilung: **27.01.2016**
(21) Anmeldenummer: 11793657.5
(22) Anmeldetag: 23.11.2011
(51) Int. Cl.: G06K 19/067, H05K 3/10, H01F 41/04, H01F 17/00, H01L 21/67

(54) **LEITERBAHNANORDNUNG FÜR TRAGBARE DATENTRÄGER**
CONDUCTOR TRACE ARRANGEMENT FOR PORTABLE DATA CARRIERS
CONFIGURATION DE CIRCUIT IMPRIME POUR UN SUPPORT DE DONNÉES PORTABLE

(30) Priorität: 24.11.2010 DE 102010052401
(43) Veröffentlichungstag der Anmeldung: 02.10.2013
(73) Patentinhaber: Giesecke & Devrient GmbH, 81677 München (DE)
(72) Erfinder: BALDISCHWEILER, Michael, 81825 München (DE)
(86) Internationale Anmeldenummer: PCT/EP2011/005900
(87) Internationale Veröffentlichungsnummer: WO 2012/069189

(56) Entgegenhaltungen:
- DE-A1- 19 620 275
- DE-A1-102007 014 501
- DE-A1-102008 003 952
- US-A1- 2009 005 117

## Beschreibung

Die Erfindung betrifft tragbare Datenträger mit einer elektronischen Schaltung und einer Ferritschicht zur Beeinflussung von auf die elektronische Schaltung wirkenden elektromagnetischen Feldern. Insbesondere richtet sich die Erfindung auf ressourcenbeschränkte tragbare Datenträger mit einer über induktive Kopplung arbeitenden Datenkommunikationseinrichtung.

Tragbare Datenträger im Sinne der vorliegenden Erfindung sind insbesondere kleinbauende, kartenförmige Datenträger in Form von Speicher- oder ICkarten, wie Speicherkarten vom Typ micro Secure Digital (micro SD), Compact Flash, Micro Drive, Memory Stick, Secure Digital Card, Multimedia Card, xD-Picture Card oder Smart Media Card, Chipkarten oder SIM-Karten. Derartige Datenträger sind aufgrund ihrer vorgegebenen baulichen Kleinheit ressourcenbeschränkt und besitzen regelmäßig keine eigene Nutzerschnittstelle.

Es ist bekannt, tragbare Datenträger der genannten Art mit einer induktiv koppelnden, kontaktlosen Datenkommunikationseinrichtung auszustatten, die zur Datenübertragung eine Antennenspule umfassen. Eine solche induktiv koppelnde Datenkommunikationseinrichtung kann beispielsweise eine RFID-Transpondereinheit sein oder eine Kommunikationseinheit zur Nahfeldkommunikation gemäß dem NFC-Standard (Near Field Communication). Grundlagen dieser Kommunikationseinrichtungen und Anwendungen in tragbaren Datenträgern sind u.a. in dem RFID-Handbuch, 5. Auflage von K. Finkenzeller, Hanser Verlag München, beschrieben.

Die Funktionsfähigkeit von tragbaren Datenträgern mit induktiv koppelnder Datenkommunikationseinrichtung wird häufig beeinträchtigt, wenn sie - bestimmungsgemäß - in ein Nutzerendgerät, insbesondere Nutzerendgeräte zur Mobilkommunikation wie Handys, Smartbooks, Netbooks oder Notebooks, eingesetzt werden. Durch metallische Komponenten in den Nutzerendgeräten, z.B. Batterieanordnungen oder metallische Gehäuse, kommt es dann zu einer Schwächung der mit der elektronischen Schaltung auf dem Datenträger wechselwirkenden elektromagnetischen Felder.

Um solchen Schwächungen entgegenzuwirken wird in dem genannten RFID-Handbuch von K. Finkenzeller vorgeschlagen, zwischen einer Metallfläche und einer Antennenspule eine Ferritschicht anzubringen, die die Abschwächung des elektromagnetischen Feldes unterbindet. Gemäß RFID-Handbuch sind die wesentlichen Charakteristiken von Ferriten, dass sie einen hohen spezifischen elektrischen Widerstand aufweisen, der je nach Werkstoff 1 bis 10⁶ Ωm beträgt, gegenüber 10 bis 10⁵ Ωm bis 10 bis 10⁴ Ωm bei Metallen. Infolgedessen sind Wirbelstromverluste klein. Gleichzeitig besitzen Ferrite eine hohe relative Permeabilität, die bis in eine Größenordnung von µᵣ = 2000 reichen kann. Am Markt verfügbare Ferritfolien weisen im Frequenzbereich um 1356 MHz typischerweise eine relative Permeabilität µᵣ von 5 bis 200 auf. Die relative Permeabilität µᵣ ist eine Materialkonstante, die charakterisiert, wie sich die magnetische Flussdichte B im Raumbereich des Materials ändert, wenn man das Material in ein Magnetfeld der magnetischen Feldstärke H einbringt.

Für tragbare Datenträger wurde ausgehend von den vorstehend erwähnten Erkenntnissen vorgeschlagen, diese mit einer oder ggf. auch mehreren Ferritschichten zu versehen, die die Antennenspule tragende Schicht unterlegt oder, bei mehreren Ferritschichten, die die elektronische Schaltung einschließlich der Antennenspule sandwichen. Die Ferritschichten bewirken, dass ein ressourcenbeschränkter tragbarer Datenträger mit einer antennenbasierten induktiv koppelnden Datenkommunikationseinrichtung auch dann stabil und über eine hinreichende Reichweite mit einem Lesegerät kommunizieren kann, wenn er in ein Nutzerendgerät eingesetzt wurde.

Die zusätzlichen Ferritschichten beanspruchen allerdings einen Teil des Volumens des tragbaren Datenträgers, das damit für andere Zwecke nicht mehr zur Verfügung steht. Da die äußeren Abmessungen von tragbaren Datenträgern regelmäßig mit sehr kleinen Werten fest vorgegeben und praktisch nicht veränderbar sind, kann das Einbringen einer oder mehrerer zusätzlicher Ferritschichten dazu führen, dass andere Komponenten des tragbaren Datenträgers verkleinert werden müssen. Der damit einhergehende Aufwand kann beträchtlich sein.
Die DE 10 2008 003 952 offenbart eine Ferritstruktur als Träger einer Schaltung.

Aus der JP 2006140 670 A ist es bekannt zur Herstellung einer mit einem IC zu verbindenden Antennenstruktur für ein IC-Tag eine Papierträgerschicht mit einer elektrisch leitfähigen Farbe zu beschichten. Anschließend wird durch Wärmeeintrag mittels eines Lasers ein Teil der leitfähigen Farbe wieder entfernt, so dass nur die Antennenstruktur auf dem Trägerpapier verbleibt.

Aus der DE 43 01 570 B4 ist ein Verfahren zur Herstellung einer Induktionsspule für den Einbau in einen Chip bekannt. Als Trägermaterial dient bei diesem Verfahren eine Ferritschicht. Darauf wird eine Leiterschicht aufgebracht, aus der anschließend durch Entfernen von nicht benötigtem Leitermaterials mittels Laserlichtes die Induktionsspule herausgeformt wird.

Es ist Aufgabe der Erfindung einen Weg für eine möglichst platzsparende Ausbildung einer Ferritschicht in einem tragbaren Datenträger aufzuzeigen. Diese Aufgabe wird gelöst durch die Erfindung, so wie sie in den unabhängigen Ansprüchen definiert wird. Die abhängigen Ansprüche richten sich auf bevorzugte Ausführungsbeispiele.

Erfindungsgemäß wird die Leiterbahnstruktur nicht als separate Anordnung sondern unmittelbar in der Ferritschicht ausgebildet. Dies hat den Vorteil, dass zumindest eine separate Schicht mit einer Leiterbahnstruktur entfällt und in einem tragbaren Datenträger entsprechend mehr Bauraum für andere Komponenten zur Verfügung steht. Wird zusätzlich Bauraum nicht benötigt, kann alternativ in vorteilhafter Weise die Dicke eines tragbaren Datenträgers verringert werden.

Infolge des Wegfalls einer gesonderten Schicht für eine Leiterbahnstruktur entfallen zumindest in manchen Ausgestaltungen der Erfindung sonst notwendige Durchkontaktierungen, so dass sich die Herstellung eines tragbaren Datenträgers insgesamt vereinfacht.

Die erfindungsgemäße Anordnung zeichnet sich auch dadurch aus, dass insbesondere eine Leiterbahnstruktur mit der Funktion einer Antenne sehr einfach und kostengünstig herstellbar ist. Im Unterschied zu den sonst üblichen Verfahren ist weder ein besonderer Verlegeschritt noch ein Druckschritt noch ein Ätzschritt erforderlich. Ein weiterer Vorteil der erfindungsgemäßen Anordnung ist, dass es zumindest bei manchen tragbaren Datenträgern möglich wird, die gesamte Grundfläche für die Ausbildung insbesondere einer Antenne zu nutzen, einschließlich solcher Bereiche, die z.B. für vergleichsweise große Schnittstellenkontakte reserviert sind, so dass hier beispielsweise für die Plazierung einer verlegten Drahtantenne bislang kein Raum war. Dies gilt etwa für Datenträger im micro-SD-Format, deren eine Stirnseite für Kontaktflächen reserviert ist.

Unter Bezugnahme auf die Zeichnung wird ein Ausführungsbeispiel der Erfindung nachfolgend näher beschrieben.

Es zeigen:
- Fig. 1: eine Schrägaufsicht auf eine Leiterbahnanordnung mit der Kontur eines tragbaren Datenträgers,
- Fig. 2: einen Schnitt durch die in Fig. 1 gezeigte Leiterbahnanordnung entlang der Linie A-A,
- Fig. 3: eine Veranschaulichung der durch Lasereinwirkung erzeugten Strukturveränderung in der Ferritschicht, und
- Fig. 4: einen Querschnitt durch einen tragbaren Datenträger, der mit einer Leiterbahnanordnung nach Fig. 1 ausgestattet ist.

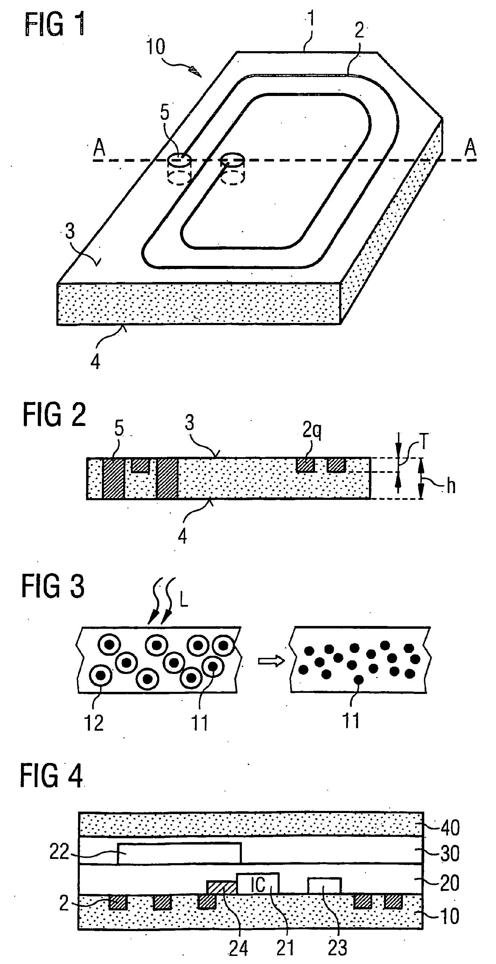

Fig.1 zeigt eine Leiterbahnanordnung 10 bestehend aus einem flächigen Träger 1 in Gestalt eines aus einer Ferritschicht ausgelösten Formstücks, in den an einer Oberseite 3 eine Leiterbahnstruktur 2 sowie an einigen Stellen zur Rückseite 4 führende Durchkontaktierungen 5 ausgebildet sind. Flächig bezeichnet einen Körper, bei dem das Verhältnis von Ober- bzw. Rückseitenoberfläche zur Querschnittsfläche so groß ist, daß Ober- und Rückseite das Erscheinungsbild des Körpers dominieren.

Alle in den Figuren dargestellten geometrischen Verhältnisse sind zudem nicht maßstabsgerecht, sondern wurden im Sinne einer guten Veranschaulichung gewählt.

Die Leiterbahnstruktur 2 besitzt in üblicher Weise ein Layout, das auf die Verwendung bzw. die Funktion der Leiterbahnstruktur 2 abgestimmt ist oder sich daraus ergibt. In einer bevorzugten Anwendung bildet sie, wie in Fig.1 angedeutet, eine Antennenspule, die Teil einer induktiv koppelnden Kommunikationseinrichtung ist und zum kontaktlosen Austausch von Signalen mit einem - nicht gezeigten - Lesegerät dient. In anderen Gestaltungen kann die Leiterbahnstruktur 2 zum Beispiel aus mehreren unabhängigen, jeweils in Durchkontaktierungen 5 endenden Verbindungen oder Verbindungslayouts bestehen, die zusammen mit einer - nicht gezeigten - weiteren Leiterbahnschicht Leiterbahnkreuzungen realisieren.

Der in Fig. 1 gezeigte Träger 1 besitzt andeutungsweise dieselbe Kontur wie ein Datenträger, in den er später eingebaut wird. Fig. 1 zeigt den Träger 1 in einem einbaufertigen oder zumindest weiterverarbeitungsfähigen Zustand. Selbstverständlich kann der Träger 1 aber auch eine andere Kontur besitzen als der tragbare Datenträger, in dem er später eingesetzt wird. Insbesondere kann der Träger eine kleinere Fläche aufweisen als der spätere tragbare Datenträger und dann beispielsweise rund, sternförmig oder auch ringförmig ausgebildet sein. Die Fläche des Trägers 1 kann auch größer sein als die Grundfläche des späteren tragbaren Datenträgers, wenn z.B. vorgesehen ist, die Randbereiche des Trägers 1 etwa rechtwinklig umzuklappen, um den Träger wannenartig mit U-förmigem Querschnitt zu gestalten.

Die Durchkontaktierungen 5 sind optional. An ihre Stelle können auch Kontaktflächen treten, über die eine Kontaktierung von der Oberseite 3 des Trägers 1 her erfolgt. Sie können auch ganz entfallen.

Der Träger 1 basiert auf einer handelsüblichen Ferritfolie, vorzugsweise ist er ein Stück aus einer Ferritfolie, aus der er z.B. durch Stanzen oder Schneiden in seine Weiterverarbeitungs- oder Endform gebracht und herausgetrennt wird. Entsprechende Ferritfolien sind z.B. von der Firma HITACHI (http://hitachi metals.co.jp) unter der Bezeichnung "FM-Shield MF-FjMF-FR Series" oder von der Firma NEC TOKIN (www://nec-tokin.com) unter der Bezeichnung "Lex Suppressor") oder von den Anbietern TTK, APSON, NEC oder EPCOS, in letzterem Fall beispielsweise unter der Bezeichnung "EPC-Folienreihe Flexield" erhältlich. Sie bestehen typischerweise aus den Kunststoff, in den Ferritpartikel eingearbeitet sind. Das Trägermaterial ist grundsätzlich nicht elektrisch leitend. Es besitzt einen Widerstand von 10 Ωm/cm. Die Stärke der Ferritfolie liegt typischerweise zwischen 10 und 100 µm, wobei auch größere Stärken von z.B. 300 µm möglich sind, während Dicken von deutlich weniger als 10 µm nur mit einigem Aufwand erzielbar sind.

Der Träger 1 kann auch eine Schichtstruktur besitzen, in der zumindest eine Außenschicht als Ferritschicht ausgeführt ist. Für die nachfolgende Beschreibung wird aber stets davon ausgegangen, daß der Träger 1 ein Stück einer Ferritfolie ist. Er weist entsprechend deren Dicke von typischerweise 10 bis 100 µm auf.

Die Ferritfolie wird typischerweise auf einer - nicht gezeigten - klebenden Grundfolie bereitgestellt; diese kann zu einem späteren Zeitpunkt entfernt werden. Es ist ferner selbstverständlich auch möglich den Träger 1 als mehrschichtigen Körper bereitzustellen, wobei zumindest einer der äußeren Schichten eine Ferritschicht ist.

Fig. 2 zeigt einen Querschnitt entlang der Linie A-A durch den in Fig.1 gezeigten Träger. An der Oberseite 3 ist in dem Trägermaterial die Leiterbahnstruktur 2 ausgebildet, wobei die Querschnitte 2q der einzelnen Leiterbahnen sich von der Oberfläche des Trägers 1 bis zu einer Tiefe T in das Trägermaterial hinein erstrecken ohne es bis zur Rückseite 4 zu durchdringen. Die Leiterbahnen besitzen einen elektrischen Widerstand, der insbesondere von ihrer Breite abhängt. Für Leiterbahnen mit einer Breite von 3 mm wurden in Versuchen Widerstandswerte von 2 Ω/cm ermittelt. Die Durchkontaktierungen 5 können, wie in Fig. 2 angedeutet, einfach als von der Oberseite 3 zur Unterseite 4 des Trägers 1 über die gesamte Dicke h des Trägers 1 durchgezogene Leiterbahnquerschnitte 5q realisiert sein. Alternativ können Durchbrüche erzeugt werden, deren vertikale Wandungen von demselben leitfähigen Material gebildet werden, das die gesamte Leiterbahnstruktur 2 bildet. Die Durchbrüche sind dann zweckmäßig mit besonders leitfähigem Material aufgefüllt, etwa mit Silberleitpaste.

Die Herstellung der Leiterbahnstruktur 2 erfolgt unmittelbar in der den Träger 1 bildenden Ferritschicht, indem der Träger 1 mit Laserstrahlung beaufschlagt wird. Eingesetzt werden kann beispielsweise eine YAG-Laserdiode mit einer Wellenlänge von z.B. 1064 Nanometer und einer Laserleistung von 33 W. Eingesetzt werden kann ebenso ein UV-Festkörperlaser mit einer Wellenlänge von 355 nm und einer Laserleistung von 2W bei einer Linse mit einer Brennweite von F=100mm sowie einer 10-fachen Strahlaufweitung. Zweckmäßig werden dabei 75% der maximalen UV-Laserleistung, d.h. z.B. etwa 1,5 W bei einem UV-Laser der Leistungsklasse 2 W, bei einer Laserpulsfrequenz von 30 kHz und einer Bewegungsgeschwindigkeit von 550 mm/s eingestellt.

Der Laserstrahl wird auf Bahnen gemäß dem gewünschten Leiterbahnlayout über den Träger 1 geführt. Bei richtig abgestimmten Laserparametern bewirkt die Lasereinstrahlung in dem Träger 1 eine Strukturveränderung des Trägermaterials, das dadurch - überraschend - elektrisch leitfähig wird. Wird die Laserleistung zu hoch gewählt verdampft das Trägermaterial und der Effekt der Strukturveränderung tritt nicht oder allenfalls vermindert ein.Ein Erklärungsmodell für die Strukturveränderung, die in Fig. 3 veranschaulicht ist, geht davon aus, dass das Trägermaterial, mithin die den Träger 1 bildende Ferritfolie, aus einem Kunststoff besteht, in dem an sich leitende Ferritkerne 11 so angeordnet sind, dass sie jeweils von Kunststoffhüllen 12 umgeben und dadurch elektrisch isoliert sind. Gemäß dem Modell werden diese die Ferritkerne 11 umgebenden Kunststoffhüllen 12 durch die Laserstrahlung entfernt und die Ferritkerne dadurch zusammengeschweißt. Das Trägermaterial wird hierbei in dem Bereich, in dem der Laser in das Material eindringt, gesintert.
Die Laserstrahlung wird so über den Träger 1 geführt, daß eine Strukturveränderung nahe der Oberseite 3 bis zu einer Tiefe T eintritt. In einer Gestaltungsvariante können auf einem Träger 1 dann auch beidseitig, d.h. an Ober-und an Unterseite Leiterbahnstrukturen 2 angelegt werden.

An Stellen, an denen das Layout Durchkontaktierungen 5 vorsieht, wird die Laserstrahlung so geführt, daß die bewirkte Strukturveränderung sich von der Oberseite 3 bis zur Unterseite 4 erstreckt. In einer Variante können für Durchkontaktierungen 5 an den davor vorgesehenen Orten Durchbrüche durch den Träger 1 erzeugt werden. Die Laserstrahlung wird an solchen Durchbrüchen vorzugsweise so geführt, daß die Wandungen solcher Durchbrüche ebenfalls strukturverändert und damit leitfähig werden.

Die fertige Leiterbahnanordnung 10 wird in einer bevorzugten Anwendung mit weiteren Schichten zu einem Inlett verbunden, das anschließend den Kern eines tragbaren Datenträgers bildet. Fig. 4 zeigt schematisch einen Querschnitt durch einen möglichen Aufbau eines solchen Inletts. Es umfasst unterseitig eine Leiterbahnanordnung 10 wie vorstehend beschrieben, darüber zwei Elektronikschichten 20, 30 sowie darüber eine Ferritschicht 40. Die einzelnen Schichten 10 bis 40 sind z.B. durch Laminieren oder Verkleben miteinander verbunden.

Die Elektronikschichten 20, 30 tragen jeweils elektronische Bauelemente und/ oder Leiterbahnen und formen zusammen mit der Leiterbahnanordnung 10 eine elektronische Schaltung. Beispielsweise kann die Leiterbahnstruktur 2 eine Antenne bilden und die elektronische Schicht 20 z.B. einen ggf. über Leiterbahnelemente 24 mit der Antenne verbundenen IC 21 enthalten, so daß beide zusammen eine Transponderanordnung bilden. In der zweiten elektronischen Schicht 30 kann beispielsweise eine Massenspeicheranordnung 22 ausgebildet sein oder sie kann eine weitere Leiterbahnstruktur zur Verbindung von in der Schicht 20 untergebrachten Bauelementen 23 enthalten. Die zweite Ferritschicht 40 fungiert als Dämpfungsschicht und verbessert den Wirkungsgrad der mit Hilfe der Leiterbahnanordnung 10 gebildeten induktiv koppelnden Kommunikationseinrichtung. Die zweite Ferritschicht 40 ist optional.

Der in Fig. 4 veranschaulichte Musteraufbau ist in jeder Beziehung nur beispielhaft zu verstehen. Anzahl, Gestaltung, Bestückung und Art von weiteren Schichten, mit denen die Leiterbahnanordnung 10 verbunden wird, können in einem weiten Rahmen variiert werden. Die Gestaltungsfreiheit ist dabei in der Regel vor allem durch die für den Datenträger gegebenen baulichen Vorgaben beschränkt. Ohne weiteres ist es insbesondere möglich, auch unterhalb der Leiterbahnanordnung 10 Schichten vorzusehen. Die Leiterbahnanordnung 10 kann auch umgekehrt eingebaut sein, so dass die Leiterbahnstruktur 2 nach außen zeigt. In diesem Fall muss die Verbindung zu den elektronischen Schichten 20, 30 über Durchkontaktierungen 5 erfolgen, wie sie in Fig. 2 dargestellt sind.

Basierend auf dem Grundgedanken, nämlich der Ausbildung einer Leiterbahnstruktur unmittelbar in einer Ferritschicht durch Anwendung von Laserstrahlung gestattet die Erfindung weitere Anwendungen und Ausgestaltungen. So ist der Einsatz erfindungsgemäßer Leiterbahnanordnungen nicht auf ressourcenbeschränkte tragbare Datenträger beschränkt sondern grundsätzlich stets dann möglich, wenn sowohl eine Ferritschicht wie eine Leiterbahnstruktur ausgebildet werden sollen.

## Patentansprüche

1. Leiterbahnanordnung für einen tragbaren Datenträger mit einem flächigen Träger und einer Leiterbahnstruktur mit einem Layout, **dadurch gekennzeichnet, dass** der Träger (1) eine nichtleitende Ferritschicht aufweist und die Leiterbahnstruktur (2) in der Ferritschicht durch Strukturveränderung des Schichtmaterials gemäß dem Layout ausgebildet ist.

2. Anordnung nach Anspruch 1, **dadurch gekennzeichnet, dass** die Leiterbahnstruktur (2) an der Oberseite (3) des Trägers (1) ausgebildet ist, wobei die Querschnitte (2q) der Leiterbahnstruktur (2) bis zu einer Tiefe (T) in den Träger (1) eindringen ohne bis zur Rückseite (4) des Trägers (1) zu reichen.

3. Anordnung nach Anspruch 1, **dadurch gekennzeichnet, dass** der Träger (1) eine Ferritfolie ist und eine Dicke (h) von 10 bis 100 µm aufweist.

4. Anordnung nach Anspruch 1, **dadurch gekennzeichnet, dass** sich die Strukturveränderung in einem begrenzten Bereich von der Oberseite (3) des Trägers (1) bis zur gegenüberliegenden Unterseite (4) erstreckt und eine Durchkontaktierung (5) bildet.

5. Inlett für einen tragbaren Datenträger mit mindestens einer Schicht (20, 30) in der ein elektronisches Bauelement angeordnet ist sowie einer Leiterbahnanordnung (10) gemäß Anspruch 1.

6. Tragbarer Datenträger beinhaltend ein Inlett nach Anspruch 5.

7. Verfahren zur Herstellung einer Leiterbahnanordnung (10), wobei eine Ferritschicht in Form einer nichtleitenden Folie, in die Ferritpartikel eingearbeitet ist, bereitgestellt und ein Layout für eine Leiterbahnstruktur vorgegeben wird, **dadurch gekennzeichnet, dass** die Ferritschicht mit Laserstrahlung bearbeitet wird, wobei die Laserstrahlung gemäß dem Layout über die Ferritfolie geführt wird, so dass das Layout elektrisch leitfähig wird.

8. Verfahren nach Anspruch 7, dadurch gekennzeichet, dass zur Erzeugung der Laserstrahlung eine YAG-Laserdiode mit einer Wellenlänge von 1064 Nanometer und einer Leistung von 33 W eingesetzt wird.

9. Verfahren nach Anspruch 7, **dadurch gekennzeichnet, dass** zur Erzeugung der Laserstrahlung eine UV-Laserdiode mit einer Wellenlänge von 355 Nanometern und einer Leistung von 2 W eingesetzt wird.

10. Verfahren nach Anspruch 7, **dadurch gekennzeichnet, dass** die Laserstrahlung mit einer Bewegungsgeschwindigkeit von 550 mm/s über die Ferritfolie geführt wird.

## Claims

1. A conducting path arrangement for a portable data carrier with a flat carrier and a conducting path structure with a layout, **characterized in that** the carrier (1) has a non-conductive ferrite layer and the conducting path arrangement (2) is formed in the ferrite layer by structural change of the layer material in accordance with the layout.

2. The arrangement according to claim 1, **characterized in that** the conductive path structure (2) is formed on the upper side (3) of the carrier (1), wherein the cross sections (2q) of the conductive path structure (2) penetrate into the carrier (1) up to a depth (T) without reaching up to the back side (4) of the carrier (1).

3. The arrangement according to claim 1, **characterized in that** the carrier (1) is a ferrite foil and has a thickness (h) of 10 to 100 µm.

4. The arrangement according to claim 1, **characterized in that** the structural change extends in a limited region from the upper side (3) of the carrier (1) up to the opposing lower side (4) and forms a feedthrough (5).

5. An inlay for a portable data carrier with at least one layer (20, 30) in which an electronic component is arranged, and a conductive path arrangement (10) according to claim 1.

6. A portable data carrier containing an inlay according to claim 5.

7. A method for manufacturing a conductive path arrangement (10), wherein a ferrite layer is made available in the form of a non-conductive foil into which ferrite particles are incorporated, and a layout for a conductive path structure is predetermined, **characterized in that** the ferrite layer is processed with laser radiation, wherein the laser radiation is guided across the ferrite foil in accordance with the layout, such that the layout becomes electroconductive.

8. The method according to claim 7, **characterized in that** for producing the laser radiation a YAG laser diode is used with a wavelength of 1064 nanometers and a power of 33 W.

9. The method according to claim 7, **characterized in that** for producing the laser radiation a UV laser diode is used with a wavelength of 355 nanometers and a power of 2 W.

10. The method according to claim 7, **characterized in that** the laser radiation is guided across the ferrite foil at a motion speed of 550 mm/s.

## Revendications

1. Agencement de piste conductrice pour un support de données portable, comportant un support plan et une structure de piste conductrice ayant un layout, **caractérisé en ce que** le support (1) comporte une couche de ferrite non conductrice et **en ce que** la structure de piste conductrice (2) est réalisée dans la couche de ferrite par modification de structure du matériau de couche conformément au layout.

2. Agencement selon la revendication 1, **caractérisé en ce que** la structure de piste conductrice (2) est réalisée à la face supérieure (3) du support (1), les sections transversales (2q) de la structure de piste conductrice (2) pénétrant dans le support (1) jusqu'à une profondeur (T) sans atteindre la face arrière (4) du support (1).

3. Agencement selon la revendication 1, **caractérisé en ce que** le support (1) est une feuille de ferrite et a une épaisseur (h) de 10 à 100 µm.

4. Agencement selon la revendication 1, **caractérisé en ce que** la modification de structure s'étend dans une zone limitée de la face supérieure (3) du support (1) jusqu'à la face inférieure (4) opposée et constitue une connexion transversale (5).

5. Intercalaire destiné à un support de données portable, comportant au moins une couche (20, 30) dans laquelle un composant électronique est agencé ainsi qu'un agencement de piste conductrice (10) conformément à la revendication 1.

6. Support de données portable, comprenant un intercalaire selon la revendication 5.

7. Procédé de fabrication d'un agencement de piste conductrice (10), une couche de ferrite étant mise à disposition sous forme d'une feuille non conductrice dans laquelle des particules de ferrite sont incorporées, et un layout pour une structure de piste conductrice étant prescrit, **caractérisé en ce que** la couche de ferrite est traitée avec des rayons laser, le rayonnement laser étant guidé conformément au layout sur la feuille de ferrite, de telle sorte que le layout devient électroconducteur.

8. Procédé selon la revendication 7, **caractérisé en ce que**, pour la génération du rayonnement laser, une diode laser YAG ayant une longueur d'onde de 1064 nanomètres et une puissance de 33 W est mise en oeuvre.

9. Procédé selon la revendication 7, **caractérisé en ce que**, pour la génération du rayonnement laser, une diode laser UV ayant une longueur d'onde de 355 nanomètres et une puissance de 2 W est mise en oeuvre.

10. Procédé selon la revendication 7, **caractérisé en ce que** le rayonnement laser est guidé à une vitesse de déplacement de 550 mm/s sur la feuille de ferrite.
